# EUROPEAN PATENT SPECIFICATION

(11) **EP 3 496 520 B1**
(45) Date of publication and mention of the grant of the patent: **29.09.2021**
(21) Application number: 17205315.9
(22) Date of filing: 05.12.2017
(51) Int. Cl.: H05K 7/20

(54) **CONTROL OF HEATED AIR IN DEVICES**
STEUERUNG VON ERWÄRMTER LUFT IN VORRICHTUNGEN
RÉGULATION DE L'AIR CHAUFFÉ DANS DES DISPOSITIFS

(43) Date of publication of application: 12.06.2019
(73) Proprietor: Vestel Elektronik Sanayi ve Ticaret A.S., 45030 Manisa (TR)
(72) Inventor: Sariarslan, Muhammet Kürsat, 45030 Manisa (TR)
(74) Representative: Schmidt, Steffen J.

(56) References cited:
- US-A1- 2010 226 090
- US-A1- 2012 156 981
- US-A1- 2014 073 234
- US-B1- 6 340 874

## Description

### Technical Field

The present disclosure generally relates to the field of ventilation in a device. More specifically, the present disclosure relates to a system for controlling heated air in device and to a method thereof.

### Background

For today's devices which generate heat inside, such as electronic devices, the created heat inside is one of the most common and crucial problems with these devices. Internally heated air of the devices generated by components of the devices adversely affects operations of the devices. The generated heat may significantly shorten the devices' lives, and in some cases, the generated heat in high temperature of the components in the devices may even cause fire.

In this regard, most of the devices take advantage of heatsinks and/or thermal conductors. To this purpose, there must be at least one air flowing area to transfer heat from inside of the devices to outside. Generally, several apertures may be used for air ventilation of the devices. However, it is not simple to optimize configuration of the ventilation holes, since if the size or the number of the holes are bigger or more, it might occur some safety and dust problems. However, if there is too small or few holes in the devices, it may not be sufficient to ventilate all of the heated air to outside and thereby not enough to cool down the devices.

US 2014/073234 A1 relates to a method comprising the steps of: creating an airflow in a chassis, wherein the chassis includes a first cooling zone with a first electronic component, a second cooling zone with a second electronic component located downstream of the first cooling zone, and a bypass zone which allows a portion of the airflow to bypass the first and second cooling zones; and modifying the airflow from the bypass zone into the second cooling zone.

US 2012/156981 A1 relates to a multizone variable damper comprising: two or more air passageway zones defined by movable members, the positions of the movable members determining an air passageway opening in each of the two or more air passageway zones; the movable members being movable relative to each other such that the size of the air passageway opening in each of the two or more air passageway zones can be different than the size of the air passageway opening in the other of the two or more air passageway zones; and actuators that move the movable members relative to each other.

### Problem

It is thus an object of the present disclosure to provide an effective way for a system to control heated air in a device that avoids one or more of these, or other, problems.

### Summary

According to a first aspect, a system for controlling heated air in a device that is partitioned into two or more zones is provided. The system comprises one or more temperature sensors configured to measure air temperature of each of the two or more zones and one or more moving components configured to form one or more air channels to transfer the heated air. The system further comprises a controller configured to receive the measured air temperature of each of the two or more zones from the one or more sensors, determine whether the measured air temperature of each of the two or more zones is above a threshold value corresponding to each of the two or more zones, and manipulate at least one of the one or more moving components for the heated air to bypass a zone among the two or more zones, when the measured air temperature of the zone is above its threshold value.

By way of example, but not limitation, the device may be any one of an electronic device, an automobile, an engine or a mechanical device which may comprise one or more components generating thermal energy, thereby increasing its internal air temperature during operation. The air in high temperature heated by the one or more components of the device rises upwards. In this regard, when the measured air temperature of the zone is determined as above its threshold value, the heated air which increases the air temperature of the zone may be generated from under the zone in the device, for example, especially in case of a vertically structured device.

By way of example, but not limitation, the two or more zones may be either a physically separated compartment by any component of the device or an arbitrarily separated area regardless of structural limitation. That is, when the device is partitioned into two or more zones, it would be understood by the skilled in the art that the two or more zones of the device can be also defined as a virtual area which is conceptually partitioned based on the flow of the heated air in the device. By way of example, but not limitation, the device may be partitioned into two or more zones according to characteristics of at least one component belonging to each of the two or more zones, the at least one component being operated under control of the device. For example, the characteristics as a basis to partition the device into the two or more zones may be at least one of a degree of thermal energy which the at least one component generates, thermal resistance, life expectancy and a position of the at least one component, and a structure of the device which also may determine positions of the one or more moving components in the device. By way of example, but not limitation, the one or more moving components may be positioned in the device according to at least one of the number and positions of the two or more zones, and a structure of the device.

By way of example, but not limitation, more than one temperature sensors may be positioned at each of the two or more zones. Furthermore, there may be more temperature sensors positioned in an area of the device which is not classified as a zone in the device. On the other hand, at least one of the lowest zones of the device even may not have a temperature sensor thereof. Since, as mentioned above, the heated air has a property to rise upward, temperature of the upper zones may increase more frequently than that of the lowest zones and thus the upper zones may only need to be bypassed by the heated air. Furthermore, structurally, it may be not possible for the heated air to bypass the lowest zones of the device. It will be understood by those skilled in the art that the structure of the device including the number and positions of the partitioned zones, temperature sensors and moving components may be varied according to various embodiments. In this way, it can be ensured that components of the device can be performed in preferred temperature, since the heated air can bypass the zone of which measured air temperature is determined as too high for the component to operate and be transferred via the formed one or more air channels.

When the measured air temperature of the zone among the two or more zones is determined as above its threshold value and the heated air is thus to bypass the zone, the controller may further manipulate at least one of the one or more moving components for the heated air to pass through at least one of other zones of which measured air temperatures are below their respective threshold values via the formed one or more air channels. In this way, it can be ensured that components of the device can be performed in preferred temperature and the internal temperature of the device will not reach to critical temperature which hinders the performance of the device. This is because at least one air channel where the heated air generated in different areas in the device flows and ventilates can be formed alternately at different zones of which air temperatures are kept low among the two or more zones. Thus, the heated air can be effectively distributed through the device while flowing and, for example, eventually transferred to outside of the device. Furthermore, the present invention does not require the use of large and bulky refrigerant or fan structures and also fewer ventilation holes are required as well. Thereby, not only can design obstacles in layout design due to heat be removed, but also the dust and safety problems caused by a lot of ventilation holes can be prevented.

The one or more temperature sensors may further periodically measure the air temperature of each of the two or more zones. By way of example, but not limitation, the one or more temperature sensors may periodically measure the air temperature of each of the two or more zones simultaneously. Alternatively, the period of measuring the air temperature of each of the two or more zones may be set up differently from each other based on the characteristics of at least one component belonging to each of the two or more zones. The characteristics may be at least one of a rate of thermal energy generation by the at least one component, a position of the at least one component and a structure of the device.

In this regard, for example, the controller may receive the air temperature of each of the two or more zones from the one or more temperature sensors periodically. Every period of measuring the air temperature of each of the two or more zones, the controller may determine whether there is any zone of which measured air temperature is above its corresponding threshold value, and if any, the controller may manipulate at least one of the one or more moving components for the heated air to bypass the corresponding zone and pass through at least one of other zones of which measured air temperatures are below their respective threshold values via the formed one or more air channels.

When the measured air temperature of the zone among the two or more zones is determined as above its threshold value and the heated air is thus to bypass the zone, then the controller may further receive the measured air temperature of the zone from the one or more temperature sensors to determine whether the measured air temperature of the zone is below its threshold value. In other words, for example, the controller may receive the measured air temperature of each of the two or more zones from the one or more sensors periodically including a newly updated air temperature of the zone of which previously measured air temperature is determined as above its threshold value. Then, the controller may determine whether the measured air temperature of each of the two or more zones is above a threshold value corresponding to each of the two or more zones and by default whether the newly updated air temperature of the zone is below its threshold value.

By way of example, but not limitation, when the newly updated air temperature of the zone is determined as still above its threshold value, the controller may keep the arrangement of the at least one of the one or more moving components for the heated air to bypass the zone continuously until the zone cools down sufficiently. Then, the controller may determine, by periodically receiving the measured air temperatures from the one or more temperature sensors, whether the measured air temperature of the zone decreases below its threshold value and whether there is any other zone of which measured air temperature is above its threshold value to be bypassed by the heated air.

By way of example, but not limitation, when the newly updated air temperature of the zone is determined as still above its threshold value and the measured air temperature of another zone among the two or more zones is determined as above its threshold value, the controller may manipulate at least one of the one or more moving components for the heated air to bypass both of the zone and the other zone. Also, the controller may further manipulate at least one of the one or more moving components for the heated air to pass through at least one of other zones of which measured air temperatures are below their respective threshold values among the two or more zones. Then, the controller may determine, by periodically receiving the measured air temperatures from the one or more temperature sensors, whether the measured air temperatures of the zone and the other zone decrease below their respective threshold values and whether there is any other zone of which measured air temperature is above its threshold value to be bypassed by the heated air.

Furthermore, when the measured air temperature of the zone of which previously measured air temperature is determined as above its threshold value is determined as below its threshold value and the measured air temperature of another zone among the two or more zones is determined as above its threshold value, the controller may manipulate at least one of the one or more moving components for the heated air to bypass the other zone and pass through at least one of other zones of which measured air temperatures are below their respective threshold values among the two or more zones including the zone which cools down below its threshold value. That is, when the newly updated air temperature of the zone of which previously measured air temperature is determined as above its threshold value is below its threshold value, the zone may be regarded as one of other zones of which measured air temperatures are below their respective threshold values. In this way, the heated air may pass through the zone of which measured air temperature is below its threshold value via the one or more air channels formed by the at least one of the one or more moving components.

The controller may further select the at least one of other zones of which measured air temperatures are below their respective threshold values in order of low temperature. Alternatively, the controller may further measure a difference value between the measured air temperature of each of other zones and the threshold value of each of other zones, and select the at least one of other zones of which measured air temperatures are below their respective threshold values in order of a large difference value. In this regard, at least one zone where the heated air is to pass through can be selected in order of capability to accept more thermal energy.

Therefore, the heated air can be efficiently distributed through the device while flowing and, for example, eventually transferred to outside of the device.

Furthermore, the threshold value corresponding to each of the two or more zones may be set up differently based on characteristics of at least one component belonging to each of the two or more zones, the at least one component being operated under control of the device. The characteristics may be at least one of a degree of thermal energy which the at least one component generates, thermal resistance, life expectancy and a position of the at least one component, and a structure of the device.

The controller may comprise at least one actuator connected to the one or more moving components and configured to move the at least one of the one or more moving components to transfer the heated air. The at least one actuator may be at least one of a hydraulic actuator, a pneumatic actuator, an electric actuator, a mechanical actuator, a magnetic actuator and a thermal actuator. The at least one actuator may further move the at least one of the one or more moving components by changing a position of the at least one of the one or more moving components linearly or rotating the at least one of the one or more moving components. The one or more moving components may be any kind of component which can guide the air to flow.

The system may further comprise at least one ventilation hole configured to discharge the heated air transferred from the formed one or more air channels to outside of the device. The at least one ventilation hole may be positioned based on a structure of the device including the number and positions of the partitioned zones, temperature sensors and moving components. In this way, the space to be required to control the heated air in the device can be efficiently arranged by placing the one or more moving components where appropriate instead of placing the large and bulky refrigerant or fan structures. Also, fewer ventilation holes can be required. Thereby, not only can design obstacles in layout design due to heat be removed, but also the dust and safety problems caused by a lot of ventilation holes can be prevented.

According to a second aspect, a method controlling heated air in a device that is partitioned into two or more zones is provided. The method may be performed by the system according to the first aspect. All apparatus features described herein with reference to the first aspect may thus also be embodied as functions, services or steps in the method of the second aspect.

### Brief Description of the Drawings

In the following, the present disclosure will further be described with reference to exemplary implementations illustrated in the figures, in which:
- Figure 1: schematically illustrates a system for controlling heated air in a device according to the present disclosure;
- Figure 2: schematically illustrates a flowchart of a method which may be performed by the system of Figure 1.

### Detailed Description

In the following description, for purposes of explanation and not limitation, specific details are set forth in order to provide a thorough understanding of the present disclosure. It will be apparent to one skilled in the art that the present disclosure may be practiced in other implementations that depart from these specific details.

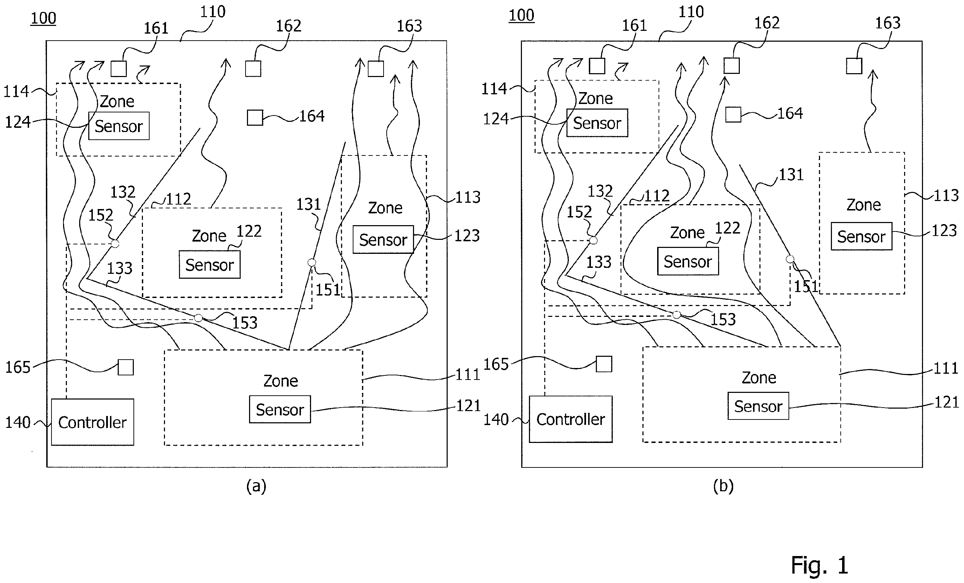

Figure 1 schematically illustrates an exemplary composition of a system 100 for controlling heated air in a device 110 that is partitioned into zones 111, 112, 113, 114. The system 100 incorporates temperature sensors 121, 122, 123, 124, moving components 131, 132, 133 and a controller 140. In Figure 1, although illustrated as each of the temperature sensors 121, 122, 123, 124 is positioned at each of the zones 111, 112, 113, 114, it will be understood by those skilled in the art that more than one temperature sensors may be positioned at each of the zones and there may be more temperature sensors positioned in an area of the device which is not classified as a zone in the device. On the other hand, at least one of the lowest zones of the device, i.e., zone 111, even may not have a temperature sensor thereof. Furthermore, it will be also understood by those skilled in the art that the structure of the device including the number and positions of the partitioned zones, temperature sensors and moving components may be varied according to various embodiments.

The temperature sensors 121, 122, 123, 124 may measure air temperature of each of the zones 111, 112, 113, 114. The controller 140 may receive the measured air temperature of each of the zones 111, 112, 113, 114 from the temperature sensors 121, 122, 123, 124 and determine whether the measured air temperature of each of the zones 111, 112, 113, 114 is above a threshold value corresponding to each of the zones 111, 112, 113, 114, and manipulate at least one of the moving components 131, 132, 133 for the heated air to bypass a zone among the zones 111, 112, 113, 114, when the measured air temperature of the zone is above its threshold value.

By way of example, but not limitation, the controller 140 may determine that the measured air temperature of the zone 112 is above its threshold value. The air in high temperature heated by one or more components of the device rises upwards. In this regard, the heated air which increases the air temperature of the zone 112 may be generated from under the zone 112 in the device 110, e.g., from zone 111. Then, the controller 140 may manipulate at least one of the moving component 131, 132, 133 to form one or more air channels to transfer the heated air and thereby for the heated air to bypass the zone 112. In Figure 1(a), the heated air is illustrated to bypass the zone 112 of which measured air temperature is above its threshold value and to pass through the zones 113, 114 via the air channels formed by the moving component 131, 132, 133.

The temperature sensors 121, 122, 123, 124 may measure the air temperature of each of the zones 111, 112, 113, 114 periodically. By way of example, but not limitation, the temperature sensors 121, 122, 123, 124 may periodically measure the air temperature of each of the zones 111, 112, 113, 114 simultaneously. Alternatively, the period of measuring the air temperature of each of the zones 111, 112, 113, 114 may be set up differently from each other. Then, the controller 140 may receive the measured air temperature of each of the zones 111, 112, 113, 114 from the temperature sensors 121, 122, 123, 124 periodically, including a newly updated air temperature of the zone 112 of which previously measured air temperature is determined as above its threshold value. That is, the controller 140 may determine whether the measured air temperature of each of the zones 111, 112, 113, 114 is above a threshold value corresponding to each of the zones 111, 112, 113, 114 and by default whether the newly updated air temperature of the zone 112 is below its threshold value.

For example, the newly updated air temperature of the zone 112 may be determined as below its threshold value and the measured air temperature of another zone 113 may be determined as above its threshold value, then the controller 140 may manipulate at least one of the moving components 131, 132, 133 for the heated air to bypass the zone 133. Also, the controller 140 may further select at least one of the zones of which measured air temperatures are below their respective threshold values for the heated air to pass through the at least one of the zones via one or more air channels. Since the newly updated air temperature of the zone 112 is determined as below its threshold value, the zone 112 may be regarded as one of the zones of which measured air temperatures are below their respective threshold values. The zone 112 may also be selected, by the controller 140, as the at least one zone where the heated air is to pass through. Therefore, in Figure 1(b), the controller 140 may manipulate the moving component 131 for the heated air to bypass the zone 113 of which measured air temperature is above its threshold value, and to pass through the zone 112 of which measured air temperature is below its threshold value. As illustrated in Figure 1(b), the heated air may pass through the zone 114 also, if the measure air temperature of the zone 114 is below its threshold value. Thus, the heated air may pass through the both of the zones 112 and 114 via the air channels formed by the moving component 131, 132, 133.

Furthermore, for example, when the controller 140 selects at least one of the zones of which measured air temperatures are below their respective threshold values for the heated air to pass through the at least one zone among the zones via one or more air channels, the controller 140 may select the at least one zone between the zones 112 and 114 in order of low temperature. By way of example, but not limitation, if the measured temperature of the zone 112 is lower than that of the zone 114, the controller 140 may further manipulate at least one of the moving components 132 and 133 for the heated air only to pass through the zone 112, while the heated air bypasses the zone 113. Alternatively, for example, the controller 140 may measure a difference value between the measured air temperature of the zone 112 and the threshold value of the zone 112 and another difference value between the measured air temperature of the zone 114 and the threshold value of the zone 114. Then, the controller 140 may select the at least one zone between the zones 112 and 114 in order of a large difference value. By way of example, but not limitation, if the measured difference value of the zone 112 is smaller than that of the zone 114, the controller 140 may further manipulate at least one of the moving components 132 and 133 for the heated air only to pass through the zone 114, while the heated air bypasses the zone 113.

The controller 140 may comprise actuators 151, 152, 153 connected to the moving components 131, 132, 133 and configured to move the at least one of the moving components 131, 132, 133 to transfer the heated air. The actuator may further move the at least one of the moving components 131, 132, 133 by changing a position of the at least one of the moving components 131, 132, 133 linearly or rotating the at least one of the moving components 131, 132, 133. For example, from Figure 1(a) to Figure 1(b), the actuator 151 of the controller 140 rotates the moving component 131 to form one or more air channels to transfer the heated air. The actuator 151, 152, 153 may be at least one of a hydraulic actuator, a pneumatic actuator, an electric actuator, a mechanical actuator, a magnetic actuator and a thermal actuator. The number of the actuators 151, 152, 153 may be varied according to various embodiments.

The system 100 may further comprise ventilation holes 161, 162, 163, 164, 165 configured to discharge the heated air transferred from the formed one or more air channels to outside of the device 110. The number of the ventilation holes 161, 162, 163, 164, 165 may be varied according to various embodiments. The ventilation holes 161, 162, 163, 164, 165 may be positioned based on a structure of the device 110 including the number and positions of the partitioned zones, temperature sensors and moving components.

Thus, the heated air can be effectively distributed through the device while flowing and, for example, eventually transferred to outside of the device. Also, the space to be required to control the heated air in the device can be efficiently arranged by placing the one or more moving components where appropriate with fewer ventilation holes instead of placing the large and bulky refrigerant or fan structures.

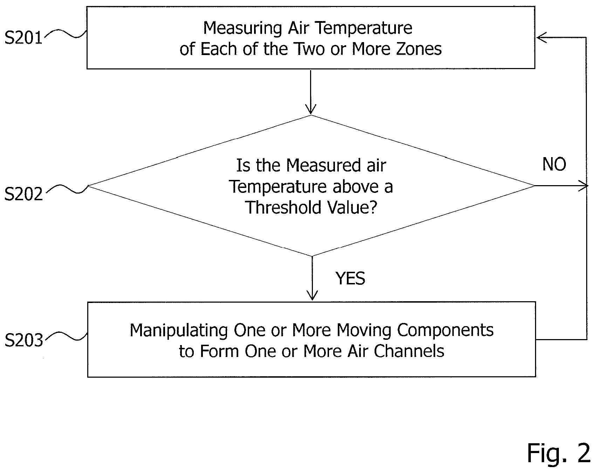

Figure 2 schematically illustrates a flowchart of a method for controlling heated air in a device, i.e., device 110. The method begins at step S201, at which one or more temperature sensors measure air temperature of each of the two or more zones. In step S202, a controller determines whether the measured air temperature of each of the two or more zones is above a threshold value corresponding to each of the two or more zones. If the controller determines that the measured air temperature of one of the two or more zones is above its threshold value, then in step S203, the controller manipulates one or more moving components to form one or more air channels to transfer the heated air such that the heated air bypasses the zone of which measured air temperature is above its threshold value. If the controller determines that there is no zone of which measured air temperature is above its threshold value, then the method returns to step S201. After the manipulation of the one or more moving components at step S203 is completed by the controller, then the method also returns to step S201. The method is repeatedly performed with a certain period by a system which controls heated air in the device, i.e., system 100.

## Claims

1. A system (100) for controlling heated air in a device (110) that is partitioned into two or more zones (111, 112, 113, 114), comprising:
one or more temperature sensors (121, 122, 123, 124) configured to measure air temperature of each of the two or more zones (111, 112, 113, 114);
one or more moving components (131, 132, 133) configured to form one or more air channels to transfer the heated air; and
a controller (140) configured to:
receive the measured air temperature of each of the two or more zones (111, 112, 113, 114) from the one or more sensors (121, 122, 123, 124),
determine whether the measured air temperature of each of the two or more zones (111, 112, 113, 114) is above a threshold value corresponding to each of the two or more zones (111, 112, 113, 114), and
manipulate at least one of the one or more moving components (131, 132, 133) for the heated air to bypass a zone among the two or more zones (111, 112, 113, 114), when the measured air temperature of the zone is above its threshold value.

2. The system of claim 1, wherein the heated air is generated from under the zone in the device (110).

3. The system of claim 1 or claim 2, wherein the controller (140) is further configured to manipulate at least one of the one or more moving components (131, 132, 133) for the heated air to pass through at least one of other zones of which measured air temperatures are below their respective threshold values via the formed one or more air channels.

4. The system of claim 3, wherein the one or more temperature sensors (121, 122, 123, 124) are further configured to periodically measure the air temperature of each of the two or more zones (111, 112, 113, 114).

5. The system of claim 4, wherein the controller (140) is further configured to receive the measured air temperature of the zone to determine whether the measured air temperature of the zone is below its threshold value.

6. The system of claim 5, wherein when the measured air temperature of the zone is determined as below its threshold value and the measured air temperature of another zone is determined as above its threshold value, the controller (140) is configured to manipulate at least one of the one or more moving components (131, 132, 133) for the heated air to bypass the other zone and pass through at least one of other zones of which measured air temperatures are below their respective threshold values among the two or more zones (111, 112, 113, 114) including the zone which cools down below its threshold value.

7. The system of any one of claims 3 to 6, wherein the controller (140) is further configured to select the at least one of other zones of which measured air temperatures are below their respective threshold values in order of low temperature.

8. The system of any one of claims 3 to 6, wherein the controller (140) is further configured to:
measure a difference value between the measured air temperature of each of other zones and the threshold value of each of other zones, and
select the at least one of other zones of which measured air temperatures are below their respective threshold values in order of a large difference value.

9. The system of any one of claims 1 to 8, wherein the threshold value corresponding to each of the two or more zones is set up differently based on characteristics of at least one component belonging to each of the two or more zones (111, 112, 113, 114), the at least one component being operated under control of the device (110).

10. The system of any one of claims 1 to 9, wherein the controller comprises at least one actuator (151, 152, 153) connected to the one or more moving components (131, 132, 133) and configured to move the at least one of the one or more moving components (131, 132, 133) to transfer the heated air, and
wherein the at least one actuator (151, 152, 153) is at least one of a hydraulic actuator, a pneumatic actuator, an electric actuator, a mechanical actuator, a magnetic actuator and a thermal actuator.

11. The system of claim 10, wherein the at least one actuator (151, 152, 153) is further configured to move the at least one of the one or more moving components (131, 132, 133) by changing a position of the at least one of the one or more moving components (131, 132, 133) linearly or rotating the at least one of the one or more moving components (131, 132, 133).

12. The system of any one of claims 1 to 10, further comprising at least one ventilation hole (161, 162, 163, 164, 165) configured to discharge the heated air transferred from the formed one or more air channels to outside of the device (110).

13. A method of controlling heated air in a device that is partitioned into two or more zones, comprising:
measuring (S210), by one or more temperature sensors, air temperature of each of the two or more zones;
determining (S220), by a controller, whether the measured air temperature of each of the two or more zones is above a threshold value corresponding to each of the two or more zones, and
manipulating (S230), by the controller, one or more moving components to form one or more air channels to transfer the heated air such that the heated air bypasses a zone among the two or more zones, when the measured air temperature of the zone is above its threshold value.

14. The method of claim 13, further comprising:
measuring (S210), by the one or more temperature sensors, the air temperature of each of the two or more zones;
determining (S220), by the controller, that the measured air temperature of the zone is below its threshold value and the measured air temperature of another zone is above its threshold value,
manipulate (S230), by the controller, at least one of the one or more moving components for the heated air to bypass the other zone and pass through at least one of other zones of which measured air temperatures are below their respective threshold values among the two or more zones including the zone which cools down below its threshold value.

## Patentansprüche

1. ein System (100) zur Regelung von erwärmter Luft in einer Vorrichtung (110), die in zwei oder mehr Zonen (111, 112, 113, 114) unterteilt ist, umfassend:
einen oder mehrere Temperatursensoren (121, 122, 123, 124), die so konfiguriert sind, dass sie die Lufttemperatur in jeder der zwei oder mehr Zonen (111, 112, 113, 114) messen;
eine oder mehrere bewegliche Komponenten (131, 132, 133), die so konfiguriert sind, dass sie einen oder mehrere Luftkanäle zur Übertragung der erwärmten Luft bilden; und
eine Steuerung (140), konfiguriert zum:
Empfangen der gemessenen Lufttemperatur jeder der zwei oder mehr Zonen (111, 112, 113, 114) von dem einen oder den mehreren Sensoren (121, 122, 123, 124),
Bestimmen, ob die gemessene Lufttemperatur jeder der zwei oder mehr Zonen (111, 112, 113, 114) über einem Schwellenwert liegt, der zu jeder der zwei oder mehr Zonen (111, 112, 113, 114) korrespondiert, und
Manipulieren der mindestens einen der einen oder mehreren beweglichen Komponenten (131, 132, 133), so dass die erwärmte Luft eine Zone der zwei oder mehreren Zonen (111, 112, 113, 114) umgeht, wenn die gemessene Lufttemperatur der Zone über ihrem Schwellenwert liegt.

2. Das System nach Anspruch 1, bei dem die erwärmte Luft von unterhalb der Zone in der Vorrichtung (110) erzeugt wird.

3. Das System nach Anspruch 1 oder Anspruch 2, wobei die Steuerung (140) ferner so konfiguriert ist, dass sie mindestens eine der einen oder mehreren beweglichen Komponenten (131, 132, 133) so manipuliert, dass die erwärmte Luft durch mindestens eine der anderen Zonen, deren gemessene Lufttemperaturen unter ihren jeweiligen Schwellenwerten liegen, durch die gebildeten einen oder mehreren Luftkanäle strömt.

4. Das System nach Anspruch 3, wobei der eine oder die mehreren Temperatursensoren (121, 122, 123, 124) ferner so konfiguriert sind, dass sie die Lufttemperatur jeder der zwei oder mehr Zonen (111, 112, 113, 114) periodisch messen.

5. Das System nach Anspruch 4, wobei die Steuerung (140) ferner so konfiguriert ist, dass es die gemessene Lufttemperatur der Zone empfängt, um festzustellen, ob die gemessene Lufttemperatur der Zone unter ihrem Schwellenwert liegt.

6. Das System nach Anspruch 5, wobei, wenn die gemessene Lufttemperatur der Zone als unter ihrem Schwellenwert liegend bestimmt wird und die gemessene Lufttemperatur einer anderen Zone als über ihrem Schwellenwert liegend bestimmt wird, die Steuerung (140) so konfiguriert ist, dass sie mindestens eine der einen oder mehreren beweglichen Komponenten (131, 132, 133) so manipuliert, dass die erwärmte Luft die andere Zone umgeht und durch mindestens eine der anderen Zonen strömt, deren gemessene Lufttemperaturen unter ihren jeweiligen Schwellenwerten unter den zwei oder mehreren Zonen (111, 112, 113, 114) liegen, einschließlich der Zone, die sich unter ihren Schwellenwert abkühlt.

7. Das System nach einem der Ansprüche 3 bis 6, wobei die Steuerung (140) ferner so konfiguriert ist, dass er die mindestens eine der anderen Zonen, deren gemessene Lufttemperaturen unter ihren jeweiligen Schwellenwerten liegen, in der Reihenfolge der niedrigen Temperatur auswählt.

8. Das System nach einem der Ansprüche 3 bis 6, wobei die Steuerung (140) ferner so konfiguriert ist, dass sie:
einen Differenzwert zwischen der gemessenen Lufttemperatur jeder der anderen Zonen und dem Schwellenwert jeder der anderen Zonen messen, und
die mindestens eine der anderen Zonen, deren gemessene Lufttemperaturen unter ihren jeweiligen Schwellenwerten liegen, in der Reihenfolge eines großen Differenzwertes auswählen.

9. Das System nach einem der Ansprüche 1 bis 8, wobei der Schwellenwert, der jeder der zwei oder mehr Zonen entspricht, auf der Grundlage von Merkmalen mindestens einer Komponente, die zu jeder der zwei oder mehr Zonen (111, 112, 113, 114) gehört, unterschiedlich eingestellt wird, wobei die mindestens eine Komponente unter der Kontrolle der Vorrichtung (110) betrieben wird.

10. Das System nach einem der Ansprüche 1 bis 9, wobei die Steuerung mindestens einen Aktuator (151, 152, 153) umfasst, der mit der einen oder den mehreren beweglichen Komponenten (131, 132, 133) verbunden und so konfiguriert ist, dass er die mindestens eine der einen oder mehreren beweglichen Komponenten (131, 132, 133) bewegt, um die erwärmte Luft zu übertragen, und
wobei der mindestens eine Aktuator (151, 152, 153) mindestens einer von einem hydraulischen Aktuator, einem pneumatischen Aktuator, einem elektrischen Aktuator, einem mechanischen Aktuator, einem magnetischen Aktuator und einem thermischen Aktuator ist.

11. Das System nach Anspruch 10, wobei der mindestens eine Aktuator (151, 152, 153) ferner so konfiguriert ist, dass er die mindestens eine der einen oder mehreren beweglichen Komponenten (131, 132, 133) bewegt, indem er eine Position der mindestens einen der einen oder mehreren beweglichen Komponenten (131, 132, 133) linear ändert oder die mindestens eine der einen oder mehreren beweglichen Komponenten (131, 132, 133) dreht.

12. Das System nach einem der Ansprüche 1 bis 10, das ferner mindestens eine Belüftungsöffnung (161, 162, 163, 164, 165) umfasst, die so konfiguriert ist, dass sie die erwärmte Luft, die von dem gebildeten einen oder den gebildeten mehreren Luftkanälen übertragen wird, nach außerhalb der Vorrichtung (110) ableitet.

13. Ein Verfahren zur Steuerung von erwärmter Luft in einer Vorrichtung, die in zwei oder mehr Zonen unterteilt ist, umfassend:
Messung (S210) der Lufttemperatur in jeder der zwei oder mehr Zonen durch einen oder mehrere Temperatursensoren;
Bestimmen (S220), durch eine Steuerung, ob die gemessene Lufttemperatur jeder der zwei oder mehr Zonen über einem Schwellenwert liegt, der jeder der zwei oder mehr Zonen entspricht, und
Manipulieren (S230) einer oder mehrerer beweglicher Komponenten durch den Regler, um einen oder mehrere Luftkanäle zu bilden, um die erwärmte Luft so zu übertragen, dass die erwärmte Luft eine Zone unter den zwei oder mehreren Zonen umgeht, wenn die gemessene Lufttemperatur der Zone über ihrem Schwellenwert liegt.

14. Das Verfahren nach Anspruch 13, das ferner umfasst:
Messung (S210) der Lufttemperatur in jeder der zwei oder mehr Zonen durch den einen oder die mehreren Temperatursensoren;
Feststellen (S220) durch den Regler, dass die gemessene Lufttemperatur der Zone unter ihrem Schwellenwert liegt und die gemessene Lufttemperatur einer anderen Zone über ihrem Schwellenwert liegt,
(S230) durch die Steuerung mindestens eine der einen oder mehreren beweglichen Komponenten so zu manipulieren, dass die erwärmte Luft die andere Zone umgeht und durch mindestens eine der anderen Zonen strömt, deren gemessene Lufttemperaturen unter ihren jeweiligen Schwellenwerten unter den zwei oder mehr Zonen liegen, einschließlich der Zone, die sich unter ihren Schwellenwert abkühlt.

## Revendications

1. Un système (100) pour contrôler l'air chauffé dans un dispositif (110) qui est divisé en deux ou plusieurs zones (111, 112, 113, 114), comprenant :
un ou plusieurs capteurs de température (121, 122, 123, 124) configurés pour mesurer la température de l'air de chacune des deux zones ou plus (111, 112, 113, 114) ;
un ou plusieurs composants mobiles (131, 132, 133) configurés pour former un ou plusieurs canaux d'air pour transférer l'air chauffé ; et
un contrôleur (140) configuré pour :
recevoir la température de l'air mesurée de chacune des deux zones ou plus (111, 112, 113, 114) à partir d'un ou plusieurs capteurs (121, 122, 123, 124),
déterminer si la température de l'air mesurée de chacune des deux zones ou plus (111, 112, 113, 114) est supérieure à une valeur seuil correspondant à chacune des deux zones ou plus (111, 112, 113, 114), et
manipuler au moins un des un ou plusieurs composants mobiles (131, 132, 133) pour que l'air chauffé contourne une zone parmi les deux ou plusieurs zones (111, 112, 113, 114), lorsque la température de l'air mesurée de la zone est supérieure à sa valeur seuil.

2. Le système de la revendication 1, dans lequel l'air chauffé est généré à partir du dessous de la zone dans le dispositif (110).

3. Le système de la revendication 1 ou de la revendication 2, dans lequel le contrôleur (140) est en outre configuré pour manipuler au moins un des un ou plusieurs composants mobiles (131, 132, 133) pour que l'air chauffé passe à travers au moins une des autres zones dont les températures d'air mesurées sont inférieures à leurs valeurs de seuil respectives via le ou les canaux d'air formés.

4. Le système de la revendication 3, dans lequel le ou les capteurs de température (121, 122, 123, 124) sont en outre configurés pour mesurer périodiquement la température de l'air de chacune des deux zones ou plus (111, 112, 113, 114).

5. Le système de la revendication 4, dans lequel le contrôleur (140) est en outre configuré pour recevoir la température d'air mesurée de la zone pour déterminer si la température d'air mesurée de la zone est inférieure à sa valeur de seuil.

6. Le système selon la revendication 5, dans lequel lorsque la température de l'air mesurée de la zone est déterminée comme étant inférieure à sa valeur de seuil et que la température de l'air mesurée d'une autre zone est déterminée comme étant supérieure à sa valeur de seuil, le contrôleur (140) est configuré pour manipuler au moins l'un des un ou plusieurs composants mobiles (131, 132, 133) pour que l'air chauffé contourne l'autre zone et passe à travers au moins l'une des autres zones dont les températures de l'air mesurées sont inférieures à leurs valeurs de seuil respectives parmi les deux zones ou plus (111, 112, 113, 114) incluant la zone qui se refroidit en dessous de sa valeur de seuil.

7. Le système de l'une quelconque des revendications 3 à 6, dans lequel le contrôleur (140) est en outre configuré pour sélectionner l'au moins une des autres zones dont les températures d'air mesurées sont inférieures à leurs valeurs de seuil respectives dans l'ordre des basses températures.

8. Le système de l'une quelconque des revendications 3 à 6, dans lequel le contrôleur (140) est en outre configuré pour :
mesurer une valeur de différence entre la température de l'air mesurée de chacune des autres zones et la valeur de seuil de chacune des autres zones, et
sélectionner l'une au moins des autres zones dont les températures d'air mesurées sont inférieures à leurs valeurs seuils respectives, dans l'ordre d'une grande valeur de différence.

9. Le système de l'une quelconque des revendications 1 à 8, dans lequel la valeur de seuil correspondant à chacune des deux ou plusieurs zones est établie différemment en fonction de caractéristiques d'au moins un composant appartenant à chacune des deux ou plusieurs zones (111, 112, 113, 114), l'au moins un composant étant mis en oeuvre sous le contrôle du dispositif (110).

10. Le système de l'une quelconque des revendications 1 à 9, dans lequel le contrôleur comprend au moins un actionneur (151, 152, 153) connecté à l'un ou plusieurs composants mobiles (131, 132, 133) et configuré pour déplacer l'au moins un de l'un ou plusieurs composants mobiles (131, 132, 133) pour transférer l'air chauffé, et
dans lequel le au moins un actionneur (151, 152, 153) est au moins un actionneur hydraulique, un actionneur pneumatique, un actionneur électrique, un actionneur mécanique, un actionneur magnétique et un actionneur thermique.

11. Le système de la revendication 10, dans lequel le au moins un actionneur (151, 152, 153) est en outre configuré pour déplacer le au moins un des un ou plusieurs composants mobiles (131, 132, 133) en changeant une position du au moins un des un ou plusieurs composants mobiles (131, 132, 133) linéairement ou en faisant tourner le au moins un des un ou plusieurs composants mobiles (131, 132, 133).

12. Le système de l'une quelconque des revendications 1 à 10, comprenant en outre au moins un trou de ventilation (161, 162, 163, 164, 165) configuré pour évacuer l'air chauffé transféré depuis le ou les canaux d'air formés vers l'extérieur du dispositif (110).

13. Un procédé de contrôle de l'air chauffé dans un dispositif qui est divisé en deux zones ou plus, comprenant :
mesurer (S210), par un ou plusieurs capteurs de température, la température de l'air de chacune des deux ou plusieurs zones ;
déterminer (S220), par un contrôleur, si la température de l'air mesurée de chacune des deux zones ou plus est supérieure à une valeur de seuil correspondant à chacune des deux zones ou plus, et
la manipulation (S230), par le contrôleur, d'un ou plusieurs composants mobiles pour former un ou plusieurs canaux d'air pour transférer l'air chauffé de telle sorte que l'air chauffé contourne une zone parmi les deux zones ou plus, lorsque la température de l'air mesurée de la zone est supérieure à sa valeur seuil.

14. Le procédé de la revendication 13, comprenant en outre :
mesurer (S210), à l'aide d'un ou plusieurs capteurs de température, la température de l'air de chacune des deux ou plusieurs zones ;
déterminer (S220), par le contrôleur, que la température de l'air mesurée de la zone est inférieure à sa valeur seuil et que la température de l'air mesurée d'une autre zone est supérieure à sa valeur seuil,
manipuler (S230), par le contrôleur, au moins l'un des un ou plusieurs composants mobiles pour que l'air chauffé contourne l'autre zone et passe par au moins l'une des autres zones dont les températures d'air mesurées sont inférieures à leurs valeurs de seuil respectives parmi les deux ou plusieurs zones incluant la zone qui se refroidit en dessous de sa valeur de seuil.
